# EUROPEAN PATENT APPLICATION

(11) **EP 4 563 351 A1**
(43) Date of publication of application: **04.06.2025**
(21) Application number: 23846954.8
(22) Date of filing: 25.07.2023
(51) Int. Cl.: B41F 15/08, B41F 15/14, B41F 21/00, B41F 33/00, H05K 3/12

(54) **BATCH ALIGNMENT DEVICE FOR SCREEN PRINTER AND BATCH ALIGNMENT METHOD USING SAME**

(30) Priority: 27.07.2022 KR 20220093232
(71) Applicant: Go, Hae Yeong, Pyeongtaek-si, Gyeonggi-do 17931 (KR)
(72) Inventor: KO, Hyung Rae, Pyeongtaek-si, Gyeonggi-do 17801 (KR); GO, Hae Yeong, Pyeongtaek-si, Gyeonggi-do 17931 (KR)
(74) Representative: Danubia Patent & Law Office LLC
(86) International application number: PCT/KR2023/010731
(87) International publication number: WO 2024/025295

(57) **Abstract**

The present invention relates to a batch alignment device for screen printers and a batch alignment method using the same, and can simultaneously, collectively, and quickly align multiple printed circuit boards in multiple alignment holes formed in one alignment jig to enable components to be simplified, the weight of a device to be reduced, production process and time to be shortened, and productivity to be improved and, accordingly, enable mass production, and can quickly implement high-quality printing, which corresponds to the alignment jig and a printing pattern of the mask, on the multiple printed circuit boards, simultaneously with completion of the alignment of the multiple printed circuit boards by aligning only the X-axes and Y-axes on the planes of the printed circuit boards in the alignment jig in a state where a mask and the alignment jig are aligned.

## Description

### Technical Field

The present invention relates to a batch alignment device for screen printers and a batch alignment method using the same, and more particularly to a batch alignment device for screen printers which enables the production of multiple printed circuit boards with high print quality even with a single printing operation by simultaneously, precisely aligning the X and Y axes of multiple printed circuit boards on the plane so that solder printing can be performed in batches of small to medium-sized multiple printed circuit boards through a single screen printer, thereby enabling mass production and reducing production costs due to improved productivity and shortening of the overall production process time; and a batch alignment method using the batch alignment device.

### Background Art

Generally, with the development of the semiconductor industry, printed circuit boards are mainly produced by relying on the Surface Mount Technology (SMT) process. The SMT process, which is a soldering preprocessing operation that prints a printed circuit board by a screen printer to solder a specific pattern on the printed circuit board, includes a side conveyor that feeds the printed circuit board to a work position such that a wafer chip can be soldered on the printed circuit board, a squeeze that pushes a solder ball (solder cream) placed on a mask, a work plate, a work conveyor, and an alignment device and is composed of a screen printing work section provided under the mask.

A screen printer having the configuration inputs a printed circuit board by a side conveyor on an input side and aligns the solder surfaces on the printed circuit board with solder inlets formed by punching the mask to correspond to the solder surfaces using an unline device, and then raises a work conveyor and lowers the mask and a squeeze so that the mask and the printed circuit board are in close contact, and then moves the squeeze back and forth so that solder balls placed on the mask pass through the solder inlets on the mask, thereby arranging the solder balls on the solder surface of the printed circuit board, and then transfers the printed circuit board, where the solder balls are arranged, from a central conveyor to a discharge-side conveyor to be discharged to the outside.

A conventional unline device employed in such screen printing uses a linear motor to move each multi-stage jig, to which a printed circuit board is fixed, along the θ-axis, the X-axis, and the Y-axis, thereby aligning the solder surfaces of the printed circuit board with the solder inlet of a mask.

However, the unline device employed in the conventional screen printer had the problem that the alignment time increased because the X-axis, Y-axis, and θ-axis had to be aligned, which resulted in an increase in a printing process time through a screen printer, resulting in a significant decrease in productivity.

In addition, there is the inconvenience of having to align each printing object individually, and when aligning multiple objects at the same time, multiple alignment devices should be installed, which increases equipment costs and reduces productivity. In other words, there are frequent cases where production efficiency and product quality are adversely affected due to time constraints for individually adjusting the X-axis, Y-axis, and θ-axis of multiple printing objects one by one, and increased equipment costs due to the installation of individual additional equipment to align each printing object. In addition, when trying to print multiple objects at once, the precision of the individually operated alignment device decreases, causing printing defects on a printed circuit board, which in turn leads to product defects and significantly increases the defect rate. Furthermore, this causes production loss, which ultimately reduces productivity.

As a technology for improving such problems, there is Korean Patent Application Publication No. 10-2013-0051609, entitled "ALIGNMENT DEVICE FOR SCREEN PRINTER," published on May 21, 2013. The alignment device is composed of a main table having X-axis and Y-axis moving holes formed therein, a suction fixing table having X-axis and Y-axis alignment holes formed therein and coupled on the main table, an X-axis and Y-axis engaging reference member coupled to the upper surface of the suction fixing table, and an X-axis and Y-axis alignment means moving in the X-axis and Y-axis directions in the X-axis, Y-axis alignment holes that are connected in the same vertical line as the X-axis, Y-axis moving holes.

Examining the operational relationship through the above configuration, the printed circuit board is placed on the suction fixing table, and then, for X-axis and Y-axis alignment, the X-axis alignment shaft of the X-axis alignment means, which is protruded through the X-axis moving hole into the X-axis alignment hole, is pushed toward the X-axis engaging reference member on the suction fixing table in the X-axis direction of the printed circuit board to align it to correspond to the X-axis engaging reference member, and the Y-axis of the printed circuit board is also aligned in the same way.

The alignment device has the advantage of being able to align multiple printed circuit boards at the same time, but has the following numerous problems.

First, the alignment precision of the X-axis and Y-axis is low during the alignment operation for printing multiple printed circuit boards. First, when continuously processing X-axis and Y-axis moving holes to manufacture a main table with X-axis and Y-axis moving holes, the distance between the moving holes does not exactly match, which reduces precision. Accordingly, even if alignment is performed, the distance error between the moving holes is reflected as it is, which makes manufacturing difficult and leads to printing defects in the printed circuit board. In addition, the machining of the X-axis and Y-axis alignment holes of the suction fixing table also has the same problem, and the moving hole and the alignment hole should be exactly aligned so that the X-axis and Y-axis alignment shafts can move smoothly along the X-axis and Y-axis, which also reduces the precision during the alignment process of the printed circuit board.

Second, the alignment means including the alignment shaft for X-axis and Y-axis alignment have a considerably complex configuration, making maintenance difficult, and the weight of the alignment device increases excessively, which leads to a problem of significantly lowering the alignment speed and also lowers the production speed of the solder printing process of the printed circuit board.

Third, durability is low, and alignment failure occurs as a result. That is, when the printed circuit board moves along the X and Y axes by the alignment means, the fatigue strength increases due to the impact of contacting X and Y-axis engagement reference members, and errors frequently occur due to screw loosening that may occur due to the connection through separate screw fastening, which may also lead to printing defects.

Fourth, the number of components is significantly large, and the process increases accordingly, and there is difficulty in maintenance.

That is, in the conventional technology as mentioned above, an error may occur in the movement distance depending on whether the diameter of the alignment shaft is the same or not in addition to the limitation of the movement distance of the alignment shaft of the alignment means, if the precision and consistency of the moving hole of a base panel and the alignment hole of a suction fixing table, which can cause alignment failure in the X-axis and Y-axis alignment of multiple printed circuit boards, are not secured, which makes it difficult to align the X-axis and Y-axis. Furthermore, the installation precision of the engagement reference member also affects the alignment of the printed circuit board. In particular, when it is a single configuration in the process of joining through screw fastening of the engagement reference member, it does not have a great effect, but when it is a multiple configuration, it should be fixed in the same position, but due to the nature of screw fastening, errors may occur depending on the screw pitch or the number of turns, making it very difficult to align the multiple printed circuit boards at the same time.

In addition, as mentioned above, the number of components for configuring the alignment device increases, which leads to maintenance problems and an increase in the overall weight, which causes considerable difficulties for workers in the maintenance and replacement process.

That is, the conventional alignment device requires precision and has a large number of components to be aligned, making it difficult to install due to this, and the biggest problem is that precision and identity are difficult to work organically in the overall operation process, so the alignment precision is low, and it is still difficult to align multiple printed circuit boards at the same time.

Therefore, there is a need for an alignment device that can easily align the X-axis and Y-axis of a printed circuit board even if identity is not required and simultaneously match the printing pattern of the mask together with the alignment of the X-axis and Y-axis, in addition to simplifying components, enabling quick alignment and solder printing of the printed circuit board.

### Disclosure

### Technical Problem

Therefore, the present invention has been made in view of the above problems, and it is one object of the present invention to provide a batch alignment device for screen printers that can simultaneously, collectively, and quickly align multiple printed circuit boards, shorten the production process and time, improve productivity, and enables mass production, simplification of the number of components, and weight reduction of the device; and a batch alignment method using the batch alignment device.

It is another object of the present invention to provide a batch alignment device for screen printers that can simultaneously perform high-quality printing that matches the printing pattern of the alignment jig and the mask while completing the alignment of multiple printed circuit boards by aligning only the X-axis and Y-axis on the plane of the printed circuit board within the alignment jig in a state where the mask and the alignment jig are aligned; and a batch alignment method using the batch alignment device.

It is yet another object of the present invention to provide a batch alignment device for screen printers that enables simultaneous high-quality printing of multiple printed circuit boards by simultaneously aligning irregularly shaped printed circuit boards using only the X-axis and Y-axis, in addition to standardized printed circuit boards; and a batch alignment method using the batch alignment device.

### Technical Solution

In accordance with an aspect of the present invention, the above and other objects can be accomplished by the provision of a batch alignment device for a screen printer, the batch alignment device including: a single mask provided on an upper part of the batch alignment device, wherein the mask is formed with multiple printing patterns corresponding to multiple printed circuit boards so that the multiple printed circuit boards can be solder-printed in a single printing operation on a printing part of a screen printer, the multiple printed circuit boards are arranged to correspond directly to the multiple printing patterns formed on the mask; a cylinder 120 where a cylinder rod 122 moves up and down to its lower center; and guide shafts 110 formed on its upper surface, and is formed in a plate shape, plate-shaped base panel 100 formed below the mask; an alignment driving part 200 coupled to guide shafts 110 on an upper surface of the base panel 100, configured to move up and down according to the operation of the cylinder rod 122 as a tip of the cylinder rod 122 is coupled to a center side, and formed to be adjusted by a certain distance on the X-axis and Y-axis on the plane; a vacuum suction part 300 coupled to an upper side of the alignment driving part 200 and provided to vacuum-absorb the printed circuit board P; a carrier boat 400 loaded below the mask wherein the multiple printed circuit boards P are placed on an upper surface of the carrier boat 400; a width adjustment conveyor unit 500 coupled to an upper surface of the base panel 100 such that a left-right width of the width adjustment conveyor unit 500 can be adjusted to correspond to a left-right width of the carrier boat 400 without interference with the alignment driving part 200 wherein the carrier boat 400 with the multiple printed circuit boards P placed thereon is fed along a wire belt to be positioned below the mask and to be symmetrically arranged forward and backward; and an alignment jig 600 formed in a plate shape, formed with multiple alignment holes 602 corresponding to multiple printed circuit boards P placed on the carrier boat 400 and having formed, aligned with the mask while being spaced upward from a carrier boat by a certain distance, and provided with both left and right ends that are placed and coupled on an upper side of the width adjustment conveyor unit 500.

Meanwhile, the alignment driving part 200 may include a drive part base panel 210 provided with a guide housing 212 that is axially coupled with the guide shafts 110 formed on the upper surface of the base panel 100; and a base rod hole 214 formed in a center such that there is no interference with an up-and-down operation of the cylinder rod 122; an X-axis alignment motor 220 coupled to one of forward and backward side of an upper surface of the drive part base panel 210; a plate-shaped X-axis adjustment panel 230 coupled with a motor shaft part of the X-axis alignment motor 220, configured to move forward and backward along the X-axis corresponding to the forward and backward side of the plane according to driving of the alignment motor to simultaneously control movement of the multiple printed circuit boards placed in the carrier boat 400 in an X-axis direction so that an X-axis rail member 232 is attached to an lower surface, and provided with an X-axis rod hole 234 through which the cylinder rod 122 penetrates to ensure no interference in left-right movement along the X-axis in the center; a Y-axis alignment motor 240 coupled to one of left and right sides of an upper surface of the X-axis adjustment panel 230; and a plate-shaped Y-axis adjustment panel 250 coupled to a motor shaft part of the Y-axis alignment motor 240, provided with a Y-axis rail member 252 coupled to its lower surface to simultaneously adjust the multiple printed circuit boards P, placed in the carrier boat 400, in the Y-axis direction by moving left and right along the Y-axis corresponding to the left and right sides on the plane according to driving of the alignment motor, and provided with a rod insertion hole 254 formed such that the tip of the cylinder rod 122 is inserted into the center and a cylinder rod is coupled directly below the vacuum suction part 300 to raise and lower the vacuum suction part.

Here, diameters of the base rod hole 214 and the X-axis rod hole 234 of the alignment driving part 200 may be formed to be larger than a distance for alignment adjustment of the front-rear Y-axis and the left-right X-axis, and may be formed such that the cylinder rod 122 can move without interference within the base rod hole 214 during the forward and backward movement of the X-axis adjustment panel 230, and the cylinder rod 122 can move without interference within the X-axis rod hole 234 during the left and right movement of the Y-axis adjustment panel 250.

Meanwhile, the vacuum suction part 300 may include a vacuum base 310 in which a vacuum base 310, in which the joint hole 312 to which the tip of the cylinder rod 122 is coupled, is formed on the same vertical line as the rod insertion hole 254 formed in the Y-axis adjustment panel 250 in the center of the lower surface, is fixedly coupled to the upper surface of the Y-axis adjustment panel, and is operated to move up and down together with the alignment driving part 200 according to the operation of the cylinder rod; and a vacuum element 320 stood up to correspond to the multiple printed circuit boards P placed on the carrier boat 400 on the upper surface of the vacuum base 310, provided with the vacuum part 322 recessed from the upper surface, the vacuum suction hole 324 formed in the center of a vacuum part, and provided with the contact-fixing band 326 formed along the circumference surface of the vacuum part to make minimum contact with the circumference side of the bottom surface of the printed circuit board P.

Furthermore, the carrier boat 400 may include multiple through-absorbing parts 410 formed as a square plate, and provided such that the vacuum suction part 300 on the plane is arranged to suck the bottom surface of the printed circuit board on the plane and lifts the printed circuit board to the alignment jig; and at least two anchoring pins provided in a pair on the outer circumference sides of the through-absorbing parts 410 such that movement of the printed circuit board can be restricted on the X-axis and Y-axis lines.

Meanwhile, the width adjustment conveyor unit 500 may include an LM rail 510 formed symmetrically in the front and rear of the upper surface of the base panel 100; rail blocks 520 formed symmetrically forward and backward such that the rail blocks 520 are rail-coupled to the LM rail 510, and rail-move such that a pair of widths thereof facing each other left and right are narrowed or widened; width-adjusting spiral shafts 530 formed symmetrically between the LM rails 510 with positive and negative screw threads formed left and right based on the center and symmetrically formed front and back; a width-adjusting drive transmission part 540 formed with a belt and a pulley such that the width-adjusting spiral shafts 530 formed in a front-back symmetry can rotate forward and backward at the same time; a width-adjusting drive motor 550; and conveyor frames 560 formed in a " 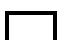 " shape such that the front and rear ends of the conveyor frames 560 are coupled to the front and rear rail blocks 520, the width-adjusting spiral shafts 530 are screw-coupled symmetrically left and right, and the widths are adjusted left and right by the width-adjusting spiral shafts 530 that rotate forward and backward by the width-adjusting drive motor 550 and the width-adjusting drive transmission part 540, and a wire belt is provided on the upper part of the conveyor frame 560 such that the carrier boat 400 on which the multiple printed circuit boards P are installed is loaded directly under the mask, which is on the side of the printing part of the screen printer, and a wire drive motor that drives the wire belt is connected to one side of the conveyor frame 560.

Meanwhile, the alignment jig 600 may include multiple alignment holes 602 formed in a square plate shape to correspond to the multiple printed circuit boards P placed on the carrier boat 400, wherein, in a state where the bottom surfaces of the multiple printed circuit boards P are sucked by the vacuum suction part 300, the X-axis and Y-axis sides of the printed circuit boards are positioned inward by the operation of the cylinder rod so that the printed circuit boards are aligned in batches by the X-axis and Y-axis movement operations of the alignment driving part 200; and finish marks 604 formed on the upper surface of the alignment jig 600 to align with the mask.

Here, a distance from an inner side surface of the alignment holes 602 to an outer side surface of the printed circuit board P may be 0.25 mm to 0.5 mm.

In accordance with another aspect of the present invention, provided is a batch alignment method, wherein a single mask having multiple printing patterns corresponding to the multiple printed circuit boards formed on the printing part of the screen printer is provided at the top such that the solder printing of the multiple printed circuit boards P can be performed in a single printing operation, and the alignment device of the screen printer is provided so that the multiple printed circuit boards are aligned so as to correspond directly to the multiple printing patterns formed on the mask, the batch alignment method including: a first alignment preparation step (S100) wherein the width of the conveyor frames 560 of the width adjustment conveyor unit 500 is adjusted to correspond to the width of the carrier boat 400 that is formed as a square plate and arranged to be first aligned by the anchoring pins 420 while the multiple printed circuit boards are placed around the through-absorbing parts 410 formed to correspond to the number of channels corresponding to the multiple printed circuit boards P to be printed, as described above; a second alignment preparation step (S200) wherein the alignment jig 600 is placed and fixed on the top of the conveyor frames 560 whose width is adjusted to correspond to the width of the carrier boat of the width adjustment conveyor unit 500, and the mask and the alignment jig 600 are matched and aligned; a carrier boat-loading step (S300) wherein the carrier boat 400 in which the multiple printed circuit boards P are placed is positioned below the alignment jig, in which the mask and the alignment jig are aligned, through the first alignment preparation step; a third alignment preparation step (S400) wherein the vacuum suction part 300 approaches the bottoms of the printed circuit boards placed in the carrier boat to vacuum-absorb by the lifting operation of the cylinder rod 122 of the base panel 100 provided below the carrier boat 400 loaded directly below the alignment jig 600 through the carrier boat-loading step, and the multiple printed circuit boards are simultaneously, batchwise separated to the upper side of the carrier boat; a fourth alignment preparation step (S500) wherein the cylinder rod 122 is further operated upward such that the multiple printed circuit boards P, which are separated in batches from the carrier boat by the vacuum suction part through the third alignment preparation step, simultaneously enter the alignment holes 602 of the alignment jig 600, so that the upper surface of the alignment jig 600 and the upper surface of the multiple printed circuit boards P, which entered the alignment holes in batches, are positioned on the same plane; a batch alignment step (S600) wherein as the X-axis adjustment panel 230 and the Y-axis adjustment panel 250 of the alignment driving part 200 are finely adjusted, the multiple printed circuit boards P are aligned in batches by adjusting a certain distance along the X-axis and Y-axis lines within the alignment holes 602; and a batch alignment finishing step (S700) wherein the multiple printed circuit boards P aligned in batches along the X-axis and Y-axis lines through the batch alignment step are fixed by suction without movement on the same plane as the upper surface of the alignment jig 600 by the vacuum suction part 300 such that solder printing is performed on the multiple printed circuit boards according to the printing pattern formed on the mask.

In the batch alignment step (S600), the multiple printed circuit boards P may enter and may be positioned in the alignment holes 602 of the alignment jig 600 by the vacuum suction part 300 so that the upper surfaces of the multiple printed circuit boards P and the upper surface of the alignment jig 600 form the same plane, the batch alignment step (S600) including: a X-axis batch alignment step (S610) wherein the X-axis adjustment panel 230 rail-coupled to the drive part base panel 210 micro-drives the vacuum suction part 300 along the X-axis according to the micro-driving of the X-axis alignment motor 220, and the multiple printed circuit boards P simultaneously move forward and backward at a certain distance in the X-axis direction within the alignment holes 602 according to the micro-driving of the vacuum suction part 300 to be collectively aligned and matched on the inner side surface of the Y-axis line within the alignment holes 602; a Y-axis batch alignment step (S620) wherein the Y-axis adjustment panel 250 rail-coupled to the X-axis adjustment panel 230 micro-drives the vacuum suction part along the Y-axis according to the micro-driving of the Y-axis alignment motor 240, and the multiple printed circuit boards P simultaneously move left and right at a certain distance in the Y-axis direction within the alignment holes 602 according to the micro-driving of the vacuum suction part 300 to be collectively aligned and matched on the inner side surface of the X-axis line within the alignment holes 602; and a final alignment step (S630) wherein the multiple printed circuit boards P are simultaneously batch-aligned on the inner side surfaces of the alignment holes 602 on the X and Y-axis lines through the X and Y-axis batch alignment step, the vacuum suction part 300 moves to the center of the alignment hole, the X and Y-axis adjustment panels 230 and 250 are driven such that the printed circuit boards move to the position where the mask and the alignment jig are markedly aligned, and the center of each of the alignment holes 602 of the alignment jig 600, which enables solder printing, are aligned to the center of each of the multiple printed circuit boards P.

Meanwhile, a distance from the inner side surface of the alignment holes 602 to the outer side surface of the printed circuit board P that has entered the alignment holes 602 at a position where the upper surface of the alignment holes 602 and the upper surface of the printed circuit board are aligned may be 0.25 mm to 0.5 mm, and a predetermined distance for the multiple printed circuit boards (P) adsorbed on the vacuum-absorbing plate 300 to move in the X-axis and Y-axis directions within the alignment holes 602 and to be aligned in batches may be 0.5 mm to 1.0 mm.

### Advantageous effects

The present invention can simultaneously, collectively, and quickly align multiple printed circuit boards in multiple alignment holes formed in one alignment jig to enable components to be simplified, the weight of a device to be reduced, production process and time to be shortened, and productivity to be improved and, accordingly, enable mass production, and can quickly implement high-quality printing, which corresponds to the alignment jig and a printing pattern of the mask, on the multiple printed circuit boards, simultaneously with completion of the alignment of the multiple printed circuit boards by aligning only the X-axes and Y-axes on the planes of the printed circuit boards in the alignment jig in a state where a mask and the alignment jig are aligned.

In addition, a batch alignment device for screen printers that enables simultaneous high-quality printing of multiple printed circuit boards by simultaneously aligning irregularly shaped printed circuit boards using only the X-axis and Y-axis, in addition to standardized printed circuit boards, on the alignment holes of the alignment jig; and a batch alignment method using the batch alignment device.

### Description of Drawings

FIG. 1 illustrates the perspective view of the entire left side of a batch alignment device for screen printers according to the present invention.
FIG. 2 illustrates the perspective view of the entire right side of a batch alignment device for screen printers according to the present invention.
FIG. 3 illustrates the perspective view of the main part of a base panel of the batch alignment device for screen printers according to the present invention.
FIG. 4 illustrates the perspective view of the main part of an alignment drive means of the batch alignment device for screen printers according to the present invention.
FIG. 5 illustrates the exploded perspective view of the alignment drive means of the batch alignment device for screen printers according to the present invention.
FIG. 6 illustrates the planar operation state diagram of the alignment drive means of the batch alignment device for screen printers according to the present invention.
FIG. 7 illustrates the enlarged perspective view of the main part of a vacuum suction means of the batch alignment device for screen printers according to the present invention.
FIG. 8 illustrates the enlarged perspective view of the main part of a carrier boat of the batch alignment device for screen printers according to the present invention.
FIG. 9 illustrates the enlarged perspective view of the main part of an alignment jig of the batch alignment device for screen printers according to the present invention.
FIG. 10 illustrates the enlarged perspective view of the main part of a width adjustment conveyor unit of the batch alignment device for screen printers according to the present invention.
FIG. 11 is a side cross-sectional view illustrating an operation relationship by an alignment drive means of the batch alignment device for screen printers according to the present invention.
FIG. 12 is a side cross-sectional view illustrating the operation relationship of a vacuum suction part of the batch alignment device for screen printers according to the present invention.
FIG. 13 is a side cross-sectional view illustrating an alignment jig-entering state of the batch alignment device for screen printers according to the present invention.
FIGS. 14 to 16 are plan views and main part plan views illustrating an alignment operation relationship of the batch alignment device for screen printers according to the present invention.
FIG. 17 is a plan view illustrating the alignment operation state of the main part of another type of printed circuit board of the batch alignment device for screen printers according to the present invention.
FIG. 18 is a block diagram illustrating an alignment method using the batch alignment device for screen printers according to the present invention.
FIG. 19 is a block diagram illustrating detailed alignment operation steps of an alignment method using the batch alignment device for screen printers according to the present invention.

### Best Mode

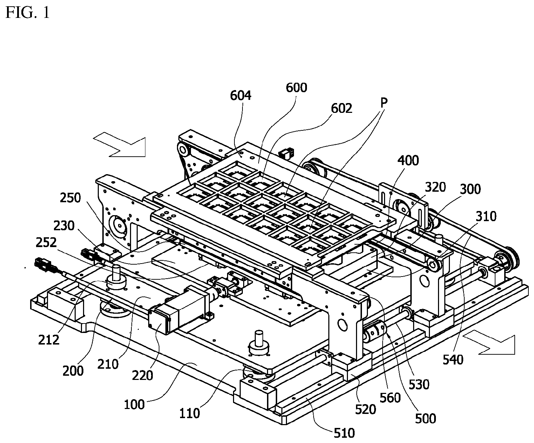

A batch alignment device for screen printers according to the present invention includes a single mask provided on the upper part of the batch alignment device, wherein the mask is formed with multiple printing patterns corresponding to multiple printed circuit boards so that the multiple printed circuit boards can be solder-printed in a single printing operation on a printing part of a screen printer, the multiple printed circuit boards are arranged to correspond directly to the multiple printing patterns formed on the mask, the simplification and weight reduction of components are possible while allowing for quick alignment, and the batch alignment device includes a base panel 100, an alignment driving part 200, a vacuum suction part 300, a carrier boat 400, a width adjustment conveyor unit 500, and an alignment jig 600 as shown in FIGS. 1 and. 2 to enable fast solder printing.

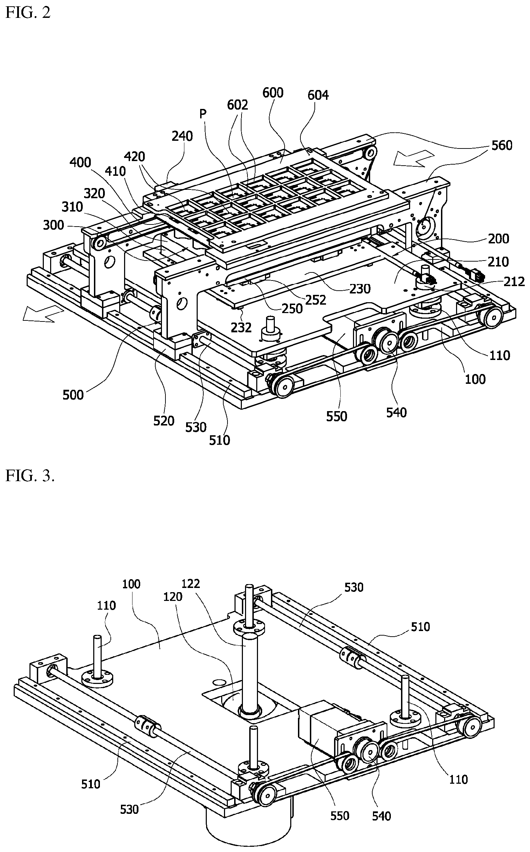

As shown in FIG. 3, the base panel 100 is positioned below the mask for solder printing of the screen printer as shown in FIG. 3, and has a cylinder 120 where a cylinder rod 122 moves up and down to its lower center, has guide shafts 110 formed on the upper surface, and is formed in a plate shape. Here, a rectangular joint hole (reference numeral omitted) is formed through the center of the plate-shaped base panel 100 such that the cylinder can be easily joined. In addition, at least two guide shafts 110 are provided such that the alignment driving part 200 described later can rise vertically without deviating from a vertical line during a vertical movement process.

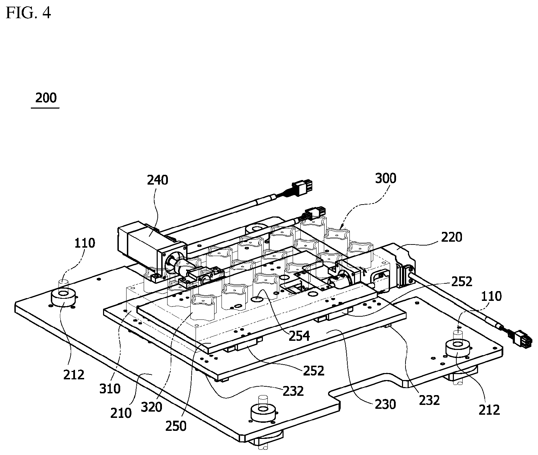

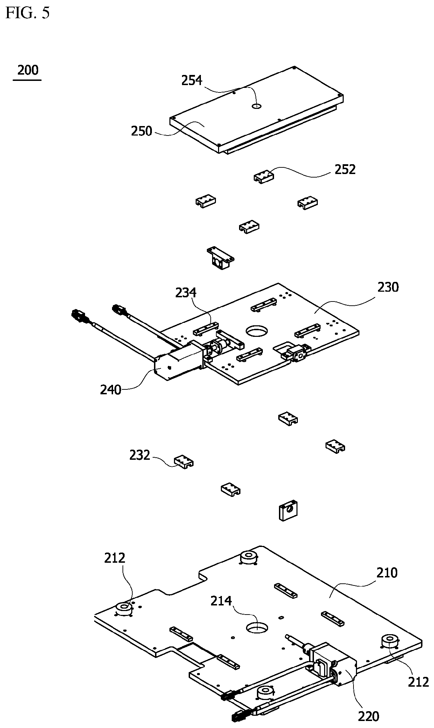

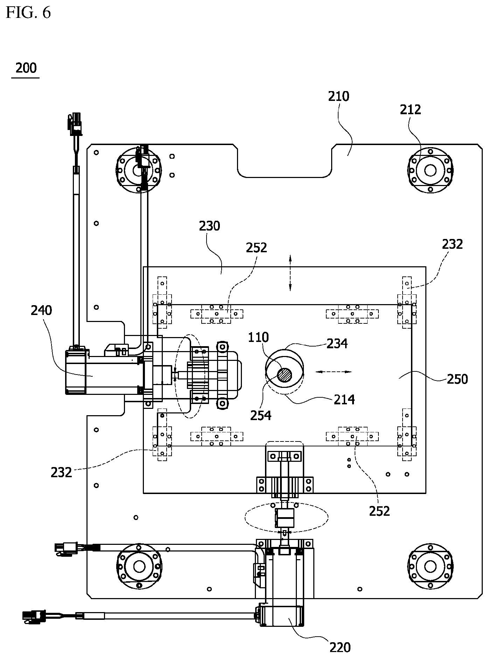

The alignment driving part 200 is provided so that the multiple printed circuit boards, which are first aligned and placed on the carrier boat described below, are simultaneously vertically raised by the alignment jig, and then the multiple printed circuit boards are simultaneously aligned by collectively adjusting the X-axis and Y-axis, as shown in FIGS. 4 to 6, the alignment driving part 200 is coupled to guide shafts 110 on an upper surface of the base panel 100, moves up and down according to the operation of the cylinder rod 122 as the tip of the cylinder rod 122 is coupled to the center side, and the alignment driving part 200 is formed to be adjusted by a certain distance on the X-axis and Y-axis on the plane. The alignment driving part 200 includes a drive part base panel 210, an X-axis alignment motor 220, an X-axis adjustment panel 230, a Y-axis alignment motor 240, and a Y-axis adjustment panel 250.

The drive part base panel 210 serves as a support for the X-axis adjustment panel 230 described below to move along a rail in the X-axis direction, is provided to vertically rise together with an X-axis adjustment panel, a Y-axis adjustment panel, and a vacuum suction part, which are described below, in a vertical line with respect to the vertical rising operation of the cylinder rod 122 provided on the base panel, provided with a guide housing 212 that is axially coupled with the guide shafts 110 formed on the upper surface of the base panel 100, and provided with a base rod hole 214 formed in the center such that there is no interference with the up-and-down operation of the cylinder rod 122.

Here, the drive part base panel 210 is formed as a square plate, and the cylinder rod 122 is provided to penetrate the base rod hole 214 formed in the center, and the cylinder rod 122 may be formed in various shapes such as a circular or square shape with an extended diameter so that the base rod hole 214 can be freely positioned within the base rod hole 214 for the alignment adjustment distance to the X-axis and Y-axis of X-axis and Y-axis adjustment panels described below. That is, it is preferable that the base rod hole 214 is formed so that there is no interference in the movement distance of the X-axis and Y-axis adjustment panels in the X-axis direction and the Y-axis direction.

The X-axis alignment motor 220 is configured to move the X-axis adjustment panel described below in the X-axis direction so that multiple printed circuit boards P can move entirely in the X-axis direction on the alignment jig and is coupled to one side of the front and rear sides of the upper surface of the drive part base panel 210 described above. That is, the body of the X-axis alignment motor 220 is coupled to the drive part base panel 210, and a motor shaft part configured to perform linear reciprocating motion by rotational force is coupled to the X-axis adjustment panel described below and configured to move forward and backward in the X-axis direction according to linear reciprocating motion by positive and negative rotational force.

The X-axis adjustment panel 230 is configured to move forward and backward in the X-axis direction according to the driving of the X-axis alignment motor described above, formed in a plate shape, and coupled with a motor shaft part of the X-axis alignment motor 220, moves forward and backward along the X-axis corresponding to the forward and backward side of the plane according to the driving of the alignment motor, and is formed to control the movement of the multiple printed circuit boards placed in the carrier boat 400 described below in the X-axis direction. The X-axis adjustment panel is provided with an X-axis rail member 232 attached to the lower surface to move back and forth horizontally along the X-axis direction, and provided with an X-axis rod hole 234 through which the cylinder rod 122 penetrates to ensure no interference in left-right movement along the X-axis in the center.

Here, the X-axis rod hole 234 also has an enlarged diameter to perform the same function as the base rod hole described above, so that the X-axis adjustment panel and the Y-axis adjustment panel are formed with an enlarged diameter so that the cylinder rod does not interfere with the inner periphery of the rod hole while moving in the X-axis and the Y-axis directions.

The X-axis alignment motor 240 is configured to move the Y-axis adjustment panel described below in the Y-axis direction so that the multiple printed circuit boards P can move entirely in the Y-axis direction on the alignment jig, and the X-axis alignment motor 240 is coupled to either the left or right side of the upper surface of the X-axis adjustment panel 230 described above. That is, the body of the Y-axis alignment motor 220 is coupled to the X-axis adjustment panel 230, and the motor shaft part configured to perform linear reciprocating motion by rotational force is coupled to the Y-axis adjustment panel described below, and configured to enable movement forward and backward from left to right in the Y-axis direction according to linear reciprocating motion by positive and negative rotational force.

The Y-axis adjustment panel 250 is configured to move forward and backward in the Y-axis direction according to the operation of the Y-axis alignment motor described above, and is formed in a plate shape to combine with the motor shaft part of the Y-axis alignment motor 240, and is formed to move left and right along the Y-axis corresponding to the left and right sides on the plane according to the operation of the alignment motor to simultaneously adjust the multiple printed circuit boards P installed on the carrier boat 400 described below in the Y-axis direction. The Y-axis adjustment panel as described above has a Y-axis rail member 252 coupled to its lower surface, such that the tip of the cylinder rod 122 is inserted through the center, the cylinder rod is coupled directly below the vacuum suction part 300 described below, and a rod insertion hole 254 is formed so that the vacuum suction part can be raised and lowered.

Here, the rod insertion hole 254 has a diameter corresponding to the diameter of the cylinder rod such that the cylinder rod 122 is coupled to the vacuum suction part and can be moved up and down. Accordingly, during the alignment process of the multiple printed circuit boards in the X-axis and Y-axis directions, the vacuum suction part and the Y-axis adjustment panel 250 move together in the X-axis and Y-axis directions. That is, the base rod hole described above is formed to prevent interference during alignment adjustment in the X-axis direction, and the X-axis rod hole is formed to prevent interference during alignment adjustment in the Y-axis direction.

That is, the diameters of the base rod hole 214 and the X-axis rod hole 234 of the alignment driving part 200 should be formed larger than the distances for alignment adjustment of the front-rear Y-axis and the left-right X-axis, so that the cylinder rod also moves together during the rail movement operation of the X-axis adjustment panel and the Y-axis adjustment panel. Accordingly, to eliminate interference, the diameters are formed such that the cylinder rod 122 can move without interference within the base rod hole 214 during the forward and backward movement of the X-axis adjustment panel 230, and the cylinder rod 122 can move without interference within the X-axis rod hole 234 during the left and right movement of the Y-axis adjustment panel 250.

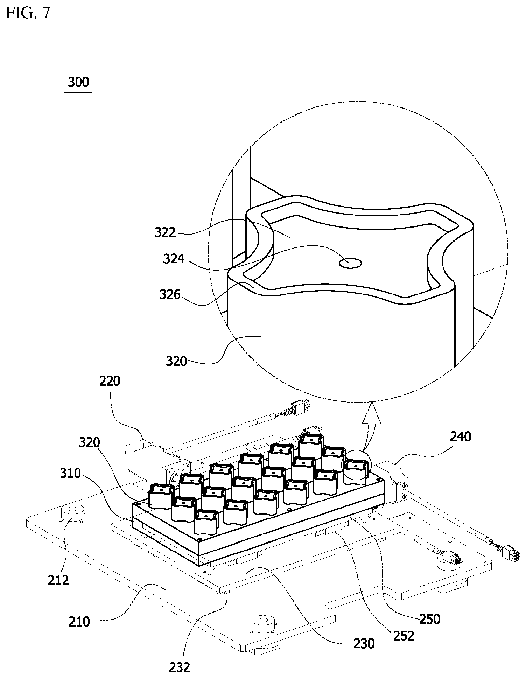

The vacuum suction part 300 is coupled to the center of the upper surface of the Y-axis adjustment panel of the alignment driving part as described above, and configured to simultaneously move the multiple printed circuit boards in the X-axis and Y-axis directions within the alignment hole of the alignment jig. As shown in FIG. 7, the vacuum suction part 300 is coupled to the upper side of the alignment driving part 200, i.e., the upper surface of the Y-axis fixing panel, and is provided to vacuum-absorb the multiple printed circuit boards P. The vacuum suction part 300 is composed of a vacuum base 310 and a vacuum base 320.

The vacuum base 310 is connected to a conventional compressor and is provided to maintain the inside of the vacuum portion of the vacuum element coupled to its top in a vacuum state so as to adsorb the multiple printed circuit boards while simultaneously being adjusted along the X-axis and Y-axis movements of the alignment driving part. The vacuum base 310 is formed so that the joint hole 312 to which the tip of the cylinder rod 122 is coupled is formed on the same vertical line as the rod insertion hole 254 formed in the Y-axis adjustment panel 250 at the center of the lower surface, and the vacuum base 310 is fixedly coupled to the upper surface of the Y-axis adjustment panel so that it is formed to move up and down together with the alignment driving part 200 according to the operation of the cylinder rod.

The vacuum element 320 is formed to correspond to the multiple printed circuit boards P installed on the carrier boat 400 on the upper surface of the vacuum base 310 to be connected so as to be vacuum-sucked from the vacuum base 310 described above. In addition, a vacuum part 322 is formed by recessing on the upper surface of one unit while configuring to correspond to the number of the multiple printed circuit boards P, a vacuum suction hole 324 is formed in the center of the vacuum part, and a contact-fixing band 326 is formed along the circumference of a vacuum part to make minimal contact with the circumference side of the bottom surface of each of the printed circuit boards P.

That is, the vacuum element 320 vertically rises toward the unline jig while penetrating from the bottom of a carrier boat to the top thereof by the operation of a cylinder rod 122 in a state of being positioned directly below a carrier boat. At this time, the bottom surface of the printed circuit board seals the vacuum part 322 while coming into contact with the contact-fixing band 326, and the residual air of the sealed vacuum part 322 is sucked through the vacuum suction hole 324 to create a vacuum state inside the vacuum part, so that the multiple printed circuit boards P, which are first aligned in the carrier boat, may approach the side of the alignment jig with one lifting operation.

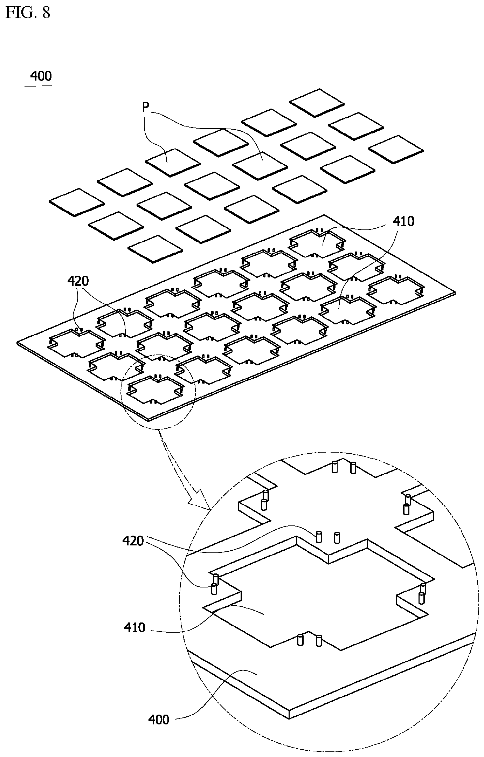

The carrier boat 400 is configured to load the multiple printed circuit boards onto the wire rail of the conveyor frame of the width adjustment conveyor unit 500, which will be described below as the printing part of the screen printer, while first aligning the multiple printed circuit boards. As shown in FIG. 8, the multiple printed circuit boards P are placed on the upper surface and loaded onto the conveyor frame below the mask. The carrier boat 400 is configured in a square plate shape in which through-absorbing parts 410 and anchoring pins 420 are formed.

The through-absorbing parts 410 are configured with a number corresponding to the multiple printed circuit boards P and formed to penetrate in a square shape on the plane formed as a square plate, and the vacuum element formed by each individual unit of the vacuum suction part 300 described above is configured to vertically rise to the alignment hole of the unline jig by absorbing the bottom surface of the printed circuit board placed on the upper parts of the through-absorbing parts while passing through the through-absorbing part. Here, the size of the through-absorbing parts is formed smaller than the printed circuit board and larger than the vacuum element of the vacuum suction part.

The anchoring pins 420 are formed on the upper surfaces of the circumference sides of the multiple through-absorbing parts so that the multiple printed circuit boards can be placed while performing the first alignment adjustment, and at least two anchoring pins are provided in a pair on the outer circumference sides of the through-absorbing parts 410 in a diagonal direction of a square so that the movement of the printed circuit boards can be restricted on the X-axis and Y-axis lines. That is, the anchoring pins 420 are configured to be formed on the outer sides of the through-absorbing parts on both sides of the corner side where the sides of the square printed circuit board meet, so that the corner side of the printed circuit board is located on the corner side of the diagonal direction of the printed circuit board, and thus the printed circuit board in the X-axis and the Y-axis direction is first aligned. That is, when the printed circuit board is excessively skewed in a specific direction among the X-axis and Y-axis directions during the loading process of the carrier boat, or when the bottom surface of the printed circuit board is contacted by the vacuum suction part and sucked in a vacuum state, the printed circuit board is configured to rise vertically without being skewed and in the first aligned state.

That is, the anchoring pins 420 serve as a guide to prevent the printed circuit board from flowing or deviating in either the X-axis or Y-axis direction during vertical rising along with the primary alignment operation of the printed circuit board. Therefore, it is desirable to form the anchoring pins 420 to stand upright in the diagonal direction of the square printed circuit board in the minimum unit, and by forming the anchoring pin 420 on each of the four sides of the printed circuit board in the drawing to be formed on the four corners, the first alignment of the printed circuit boards through the carrier boat is possible before the adjustment of the X-axis and Y-axis by the alignment jig described below.

Meanwhile, the width adjustment conveyor unit 500 is essential in the process of inserting the carrier boat and aligning the mask with the alignment jig, and is configured to adjust the width to a size suitable for the size of the carrier boat, so that the movement distance for alignment of the X-axis and Y-axis during the alignment operation is minimized. The width adjustment conveyor unit 500 is coupled to the upper surface of the base panel 100 such that the left-right width of the width adjustment conveyor unit 500 is adjusted to correspond to the left-right width of the carrier boat 400 without interference with the alignment driving part 200 described above, and the carrier boat 400 on which the multiple printed circuit boards P are placed is positioned symmetrically in the front and rear so that it is fed along a wire belt and positioned below the mask.

The width adjustment conveyor unit 500 is configured to load directly under a mask from a screen printer input part for solder printing on a general single printed circuit board, and in the present invention, to load directly under the mask to simultaneously align a carrier boat that accommodates multiple printed circuit boards and the multiple printed circuit boards accommodated in the carrier boat. That is, since a general printed circuit board is printed by being fed as a single body, a separate carrier boat is not required, and an alignment jig is also not required, and a mask pattern can be solder-printed by matching the marking points of the printed circuit board and the marking points of a mask. However, in the case of a printed circuit board of a size that cannot be fed as a single body as in the present invention or of printing multiple printed circuit boards in a single printing operation, it is necessary to simultaneously perform printing by aligning along the X-axis and Y-axis within an alignment jig that matches the marking points of a mask because the marking points of the mask do not match, thereby increasing production efficiency and shortening production time.

Accordingly, the width adjustment conveyor unit 500 according to the present invention is not significantly different from the input structure of a conventional printed circuit board, so it will be briefly described. However, the connection relationship with other components of the present invention will be described in detail.

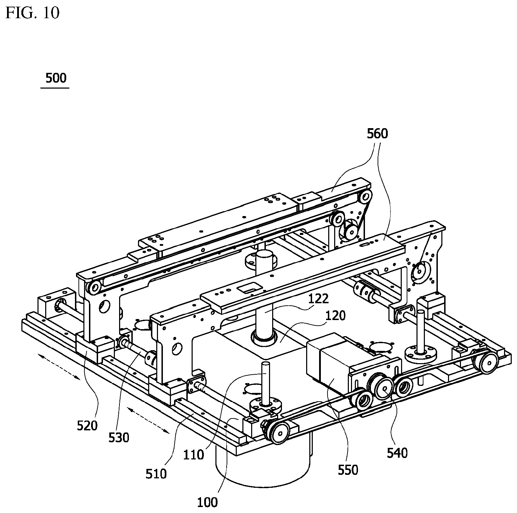

First, the width adjustment conveyor unit 500 includes an LM rail 510, rail blocks 520, width-adjusting spiral shafts 530, a width-adjusting drive transmission part 540, a width-adjusting drive motor 550, and conveyor frames 560, as shown in FIG. 10.

The LM rail 510 is mainly used when precision is required in the distance between movements, and is formed symmetrically in the front and rear of the upper surface of the base panel 100. This is because the carrier boat is inserted in the front and rear of each of the conveyor frames described below, and it should correspond to the left and right width of the carrier boat to stably position the carrier boat directly under the mask.

The rail blocks 520 are formed symmetrically in the front and rear so that a pair of widths facing each other left and right by rail-coupling to the LM rail 510 described above can move on the rail in a narrowing or widening manner. Meanwhile, the width-adjusting spiral shafts 530 are formed with positive and negative screw threads left and right based on the center, and are formed symmetrically in the front and back between the LM rails 510 formed symmetrically in the front and back. Here, half of the width-adjusting spiral shafts 530 are formed with forward-rotating screw threads, and the other half are formed with reverse-rotating screw threads, so that the conveyor frame, which will be described below, can be narrowed and widened toward the center by the driving force of the width-adjusting drive transmission part.

The width adjustment as described above is performed such that the width-adjusting drive transmission part 540 formed with a belt and a pulley such that the width-adjusting spiral shafts 530 formed to be symmetrical forward and backward rotate forward and backward at the same time; and the conveyor frames 560 configured to forward rotate the width-adjusting spiral shafts, which are symmetrical forward and backward, by the width-adjusting drive motor 550, and screwed to the width-adjusting spiral shafts are symmetrical left and right.

That is, the conveyor frames 560 are formed in a " 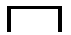 " shape such that the front and rear ends of the conveyor frames 560 are coupled to the front and rear rail blocks 520, the width-adjusting spiral shafts 530 are screw-coupled symmetrically left and right, and the widths are adjusted left and right by the width-adjusting spiral shafts 530 that rotate forward and backward by the width-adjusting drive motor 550 and the width-adjusting drive transmission part 540, and a wire belt is provided on the upper part of the conveyor frame 560 such that the carrier boat 400 on which the multiple printed circuit boards P are installed is loaded directly under the mask, which is on the side of the printing part of the screen printer, and a wire drive motor (not shown) that drives the wire belt is connected to one side of the conveyor frame 560.

Here, the width of the conveyor frames 560 is determined depending upon the left and right width size of the carrier boat. That is, when the mask and the alignment jig are changed, the size of the carrier boat also changes, so the width is adjusted accordingly to ensure that solder printing is performed smoothly.

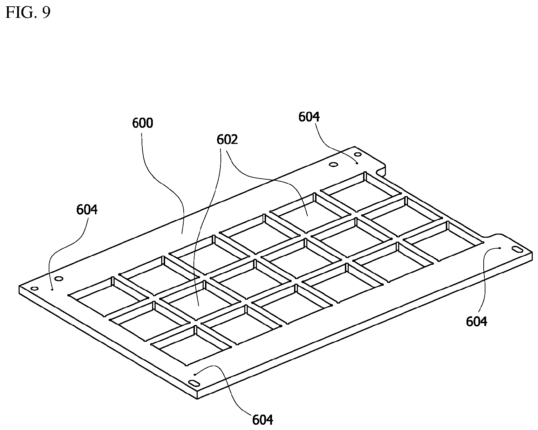

The alignment jig 600 is formed in a plate shape, is provided with multiple alignment holes 602 corresponding to the multiple printed circuit boards P placed on the carrier boat 400, and is formed such that its left and right ends are placed and coupled on the upper part of the width adjustment conveyor unit 500 while being aligned with the mask in a state of being spaced upward at a certain interval from the carrier boat. The alignment jig 600 includes alignment holes 602 and finish marks 604 as shown in FIG. 9.

The alignment holes 602 serve as a reference for simultaneously and collectively adjusting and aligning the X-axis and Y-axis while the multiple printed circuit boards are sucked by the vacuum suction part, the multiple alignment holes 602 are formed in a square plate shape to correspond to the multiple printed circuit boards P placed on the carrier boat 400, and in a state where the bottom surfaces of the multiple printed circuit boards P are sucked by the vacuum suction part 300, the X-axis and Y-axis sides of the multiple printed circuit boards P are positioned inward by the operation of the cylinder rod, so that the multiple printed circuit boards P are aligned collectively by the X-axis and Y-axis moving operation of the alignment driving part 200.

The finish marks 604 are configured to print by matching marking points and the marking points of the mask on a single-piece printed circuit board, not a printed circuit board having a size that is coupled to a carrier boat, and are formed on the upper surface of the alignment jig to be aligned with the mask. That is, the finish marks 604 perform a role like marking points, and can high-quality solder printing and significantly reduce the defect rate by aligning the printing pattern portion of the mask and the positions of the multiple printed circuit boards aligned for printing such that the alignment jig is aligned with the mask.

Here, a distance from the inner side of the alignment holes 602 to the outer side of the printed circuit board P is preferably 0.25 mm to 0.5 mm. When the printed circuit boards are placed on the carrier boat, the first alignment is actually done, but in the process where the vacuum suction part on the carrier boat sucks the printed circuit board, some of the printed circuit boards may be slightly distorted in the X-axis direction, the Y-axis direction, or the X-axis and the Y-axis direction, and the printing defects caused by this may be significant compared to the slightly changed positions. That is, since the printed circuit board changes its position in the process of being sucked by the vacuum suction part before being vertically lifted into the alignment hole of the alignment jig by the vacuum suction part, it is possible to prevent deterioration of the printing quality by aligning it. Concerning such minute position changes, since the distance at the center of the distance between the outside of the printed circuit board and the inside of the alignment hole is 0.25 mm to 0.5 mm, the distance at which the position of the printed circuit board can actually change is within ×2 of the optimal distance between the alignment hole and the printed circuit board, and alignment for high-quality printing is possible within this distance.

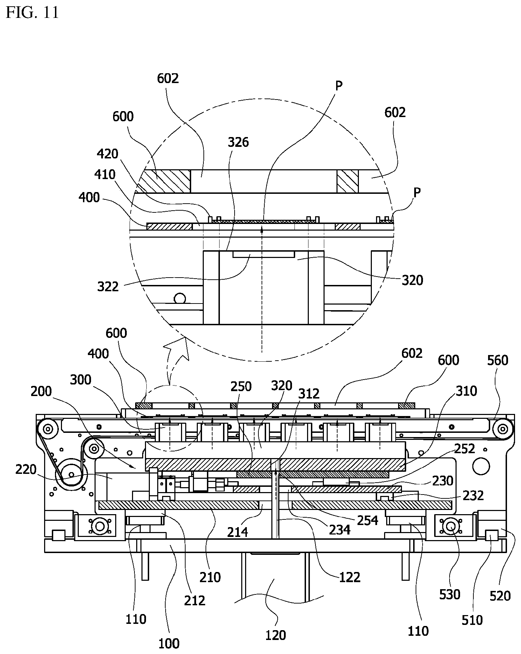

Briefly examining the operation relationship of the batch alignment device for screen printers of the present invention according to this configuration, first, a printed circuit board is placed on the through-absorbing parts 410 of the carrier boat 400 as shown in FIGS. 11 to 13. Here, the printed circuit board is first aligned and placed on the carrier boat 400 by the anchoring pin on the upper part of the through-absorbing parts 410.

Next, the left-right width of the carrier boat 400 is adjusted so that the carrier boat 400 can be loaded onto the conveyor frames 560 formed symmetrically on the left and right of the width adjustment conveyor unit 500. Here, the left-right width adjustment is performed by rotating the width-adjusting drive transmission part 540, which is operated by the operation of the width-adjusting drive motor 550, by a width adjustment screw shaft 530 having a right-hand screw thread and a left-hand screw thread formed on both sides, so that the rail blocks 520 coupled with the conveyor frames 560, which are formed symmetrically left and right, move along the LM rail 510 to adjust the width to correspond to the left-right width of the carrier boat 400.

Next, the carrier boat 400 is loaded into the conveyor frames 560 and positioned below the mask, the left and right sides of the alignment jig 600 are placed on the top of the symmetrically formed conveyor frames 560, and the through-absorbing parts 410 of the carrier boat 400 are positioned directly below the alignment holes 602 formed in the alignment jig 600, so that the printed circuit board placed on the top of the through-absorbing parts is also positioned directly below the alignment holes 602. Here, the alignment jig is installed on and fixed to the conveyor frame so that the finish marks 604 are aligned with the marking points of the mask. Accordingly, alignment can be completed by only aligning the X-axis and Y-axis of the printed circuit board within the alignment holes 602, so high-quality printing can be implemented.

Next, when the cylinder rod 122 of the cylinder 120, which is coupled to the lower center of the base panel 100, operates, in a state where the tip of the cylinder rod 122 is coupled to the joint hole 312 of the lower center of the vacuum base 310 of the vacuum suction part 300, which is coupled to the upper surface of the Y-axis adjustment panel 250 through the X-axis adjustment panel 230, the vacuum suction part 300 vertically rises to correspond to the vacuum elements 320 respectively corresponding to the through-absorbing parts 410 of the carrier boat. Next, the contact-fixing band 326 of the vacuum element 320, which has vertically ascended toward the through-absorbing parts 410, makes a line contact along the perimeter of the bottom surface of the printed circuit board, and then, according to the vacuum operation, the air inside the vacuum part is discharged through the vacuum suction hole 324 in the vacuum part 322, and the bottom surface of the printed circuit board is absorbed and fixed in a vacuum state and continues to rise vertically in the fixed state.

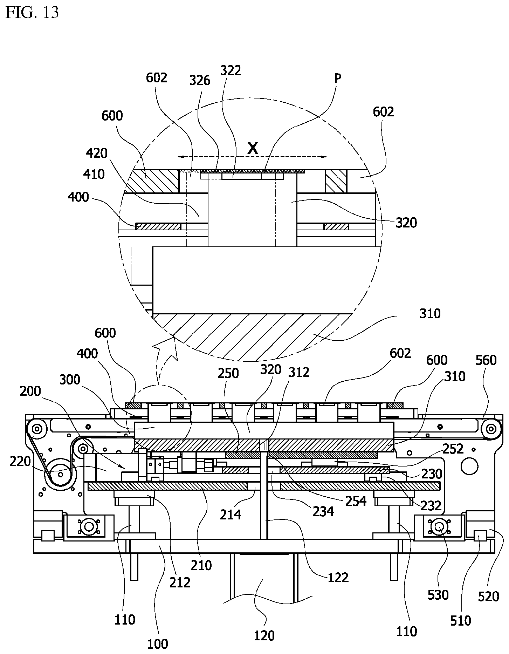

Next, as shown in FIG. 13, the printed circuit board, which continues to rise vertically, enters the mounting hole 602 of the alignment jig 600, and finally rises vertically to the point where the upper surface of the alignment jig 600 and the upper surface of the printed circuit board P are positioned on the same plane, thereby stopping the cylinder operation.

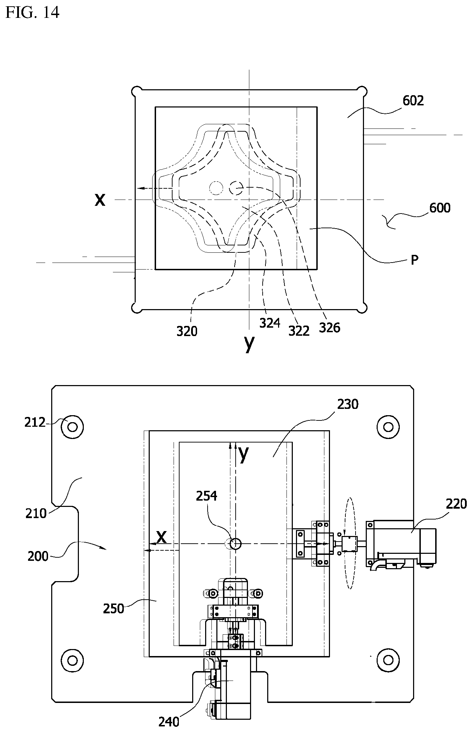

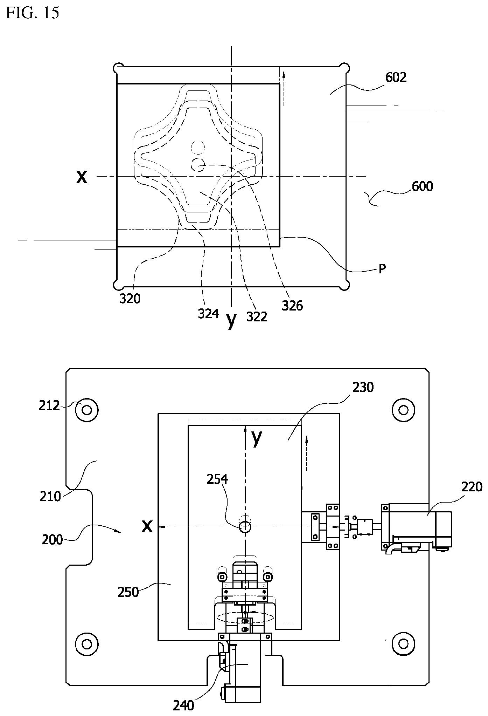

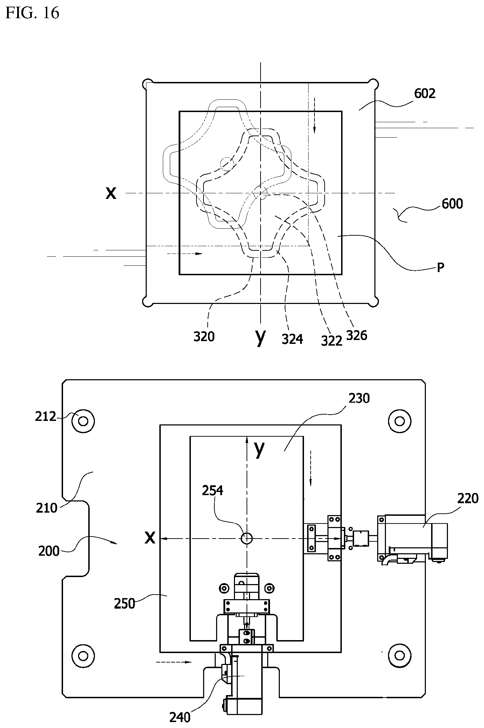

Next, as shown in FIGS. 14 to 16, the alignment of the X-axis and Y-axis adjustment panels is adjusted while the printed circuit boards are aligned in the X-axis and Y-axis directions within the alignment hole according to the driving of the X-axis and Y-axis alignment motors such that the X-axis and Y-axis of the multiple printed circuit boards are aligned simultaneously and collectively within the alignment hole of the alignment jig.

Here, by the X-axis and Y-axis alignment method, the multiple printed circuit boards positioned within the alignment holes 602 are first aligned in the carrier boat, but are slightly changed during the suction process of the vacuum suction part. Accordingly, the alignment of the multiple printed circuit boards according to the change in position is performed within the alignment holes 602. For example, when the distance from the peripheral surface of the printed circuit board to the inner side surface of the alignment hole is optimally 0.5 mm, the optimal alignment distance is 0.5 mm from the left and 0.5 mm from the right based on the X-axis in the case of the printed circuit board with the greatest change, and when the position is changed, the maximum change may be 1.0 mm by adding the distances on the left and right.

Assuming that one or more positions of the multiple printed circuit boards change in the X-axis direction as described above, the distance to the left becomes 0.7 mm if one of the printed circuit boards changes 0.3 mm to the right, and the distance to the right becomes 0.8 mm if it changes 0.2 mm to the left. Accordingly, to adjust the whole equally, the X-axis adjustment panel 230 is moved up to 1.0 mm in the X-axis direction based on either the left or right side.

If moved by 1.0 mm as described above, the printed circuit board changed by 0.3mm to the right or the printed circuit board changed by 0.2 mm to the left will both be aligned with the inner side surface of the alignment holes 602 of the Y-axis direction on either the left or right side of the X-axis direction. Of course, the remaining printed circuit boards placed in the correct position also coincide with the inner side surface of the alignment holes 602 in the Y-axis direction at the same time, so that the entire multiple printed circuit boards are aligned in the X-axis direction at the same time. Accordingly, the alignment adjustment is performed in the X-axis equally. In addition, since there is a part where the Y-axis direction is also changed in a complex manner, the Y-axis adjustment panel 250 is moved in the same way as above, so that the entire multiple printed circuit boards P are aligned with the X-axis inner side surface of the alignment hole at the same time, and thus the X-axis and Y-axis are aligned. Here, if the alignment jig is aligned with the mask pattern by adjusting the X-axis and Y-axis, the alignment adjustment can be completed and solder printing is possible with just the X-axis and Y-axis adjustments. However, since the alignment jig and the mask should be aligned such that the printing pattern is centered, the X-axis adjustment panel and the Y-axis adjustment panel are each moved by 0.5 mm after the X-axis and Y-axis alignment adjustments are completed if the point where the alignment hole is spaced 0.5 mm left and right and front and back matches the mask printing pattern. Accordingly, as the final alignment adjustment is completed, high-quality solder printing is possible without printing defects, there is no need to individually perform or do multiple printed circuit boards, and the problems of the configuration of pushing the X-axis and Y-axis by shafts as in existing technology, such as increased number of components, increased weight, poor alignment due to poor assembly, difficulty in maintenance, and limitations in not being able to universally use the size or shape of the printed circuit board, can be improved.

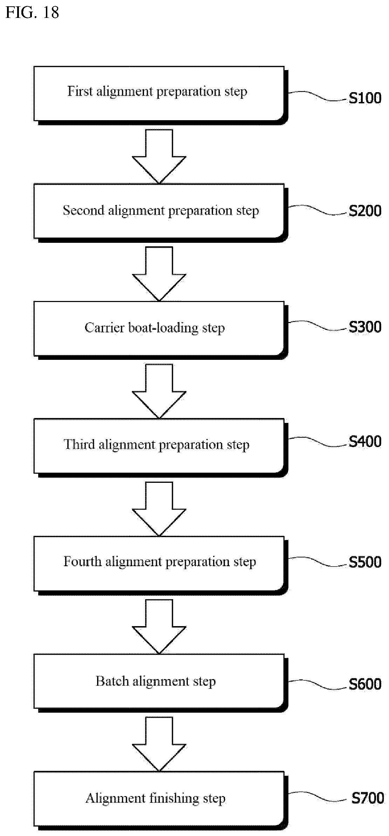

Accordingly, examining a batch alignment method using a batch alignment device for screen printers according to the present invention, the batch alignment method is characterized in that a single mask having multiple printing patterns corresponding to the multiple printed circuit boards formed on the printing part of the screen printer is provided at the top such that the solder printing of the multiple printed circuit boards P can be performed in a single printing operation, and the alignment device of the screen printer is provided so that the multiple printed circuit boards are aligned so as to correspond directly to the multiple printing patterns formed on the mask, and as illustrated in FIG. 18, the batch alignment method includes a first alignment preparation step (S100), a second alignment preparation step (S200), a carrier boat-loading step (S300), a third alignment preparation step (S400), a fourth alignment preparation step (S500), a batch alignment step (S600), and a batch alignment finishing step (S700).

**In the first alignment preparation step (S100),** the width of the conveyor frames 560 of the width adjustment conveyor unit 500 is adjusted to correspond to the width of the carrier boat 400 that is formed as a square plate and arranged to be first aligned by the anchoring pins 420 while the multiple printed circuit boards are placed around the through-absorbing parts 410 formed to correspond to the number of channels corresponding to the multiple printed circuit boards P to be printed, as described above. Here, the anchoring pins 420 are provided to align the X-axis and Y-axis of the printed circuit board by contacting the two corner sides of the printed circuit board on the upper side of the through-absorbing parts 410, may be aligned first, and may load multiple printed circuit boards as one printed circuit board by being placed on the carrier boat.

**In the second alignment preparation step (S200),** the alignment jig 600 is placed and fixed on the top of the conveyor frames 560 whose width is adjusted to correspond to the width of the carrier boat of the width adjustment conveyor unit 500, and the mask and the alignment jig 600 are matched and aligned. Here, the alignment jig is aligned in a state where the multiple printed circuit boards are loaded first or later, like a single printed circuit board, by the carrier boat where the multiple printed circuit boards are placed, and it is preferable to constitute such that the vacuum suction part-carrier boat-alignment jig-mask are positioned on the same vertical line as much as possible.

**In the carrier boat-loading step (S300),** the carrier boat 400 in which the multiple printed circuit boards P are placed is positioned below the alignment jig, in which the mask and the alignment jig are aligned, through the first alignment preparation step. Here, the same result is obtained even when the carrier boat is first loaded and positioned on the same vertical line above the vacuum suction part.

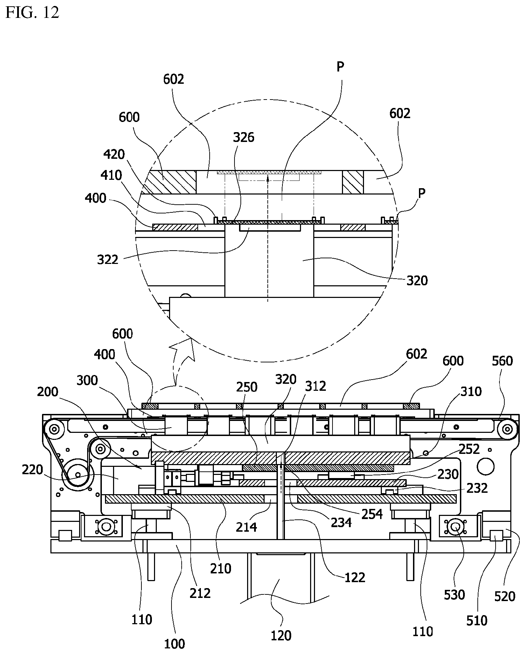

The above steps are the same as shown in FIG. 11, and subsequent steps are the same as shown in FIG. 12.

**In the third alignment preparation step (S400),** when the alignment jig is loaded directly below the alignment jig 600 through the carrier boat-loading step or positioned above the carrier boat or positioned on the upper side of the carrier boat after the carrier boat is loaded, the vacuum suction part 300 approaches the bottoms of the printed circuit boards placed in the carrier boat by the lifting operation of the cylinder rod 122 of the base panel 100 provided below the carrier boat 400 to vacuum-absorb, and the multiple printed circuit boards are simultaneously, batchwise separated to the upper side of the carrier boat. Here, since some or all of the first aligned multiple printed circuit boards change positions from the first aligned positions as described above, a batch alignment through the alignment jig is required.

**In the fourth alignment preparation step (S500),** the cylinder rod 122 is further operated upward such that the multiple printed circuit boards P, which are separated in batches from the carrier boat by the vacuum suction part through the third alignment preparation step, simultaneously enter the alignment holes 602 of the alignment jig 600, so that the upper surface of the alignment jig 600 and the upper surface of the multiple printed circuit boards P, which entered the alignment holes in batches, are positioned on the same plane. That is, when the upper surface of the alignment jig and the printed circuit board are positioned on the same plane as shown in FIG. 13, the mask is lowered to perform solder printing on the printed circuit board. At this time, if the printed circuit board is positioned lower than the alignment hole of the alignment jig, a solder printing defect occurs, and if it is higher than the upper surface of the alignment jig, a bend occurs between the printed circuit boards when solder printing with the mask, which may also cause a printing defect.

Subsequent steps are the same as shown in FIGS. 14 to 16, and the following descriptions are made with reference to the drawings.

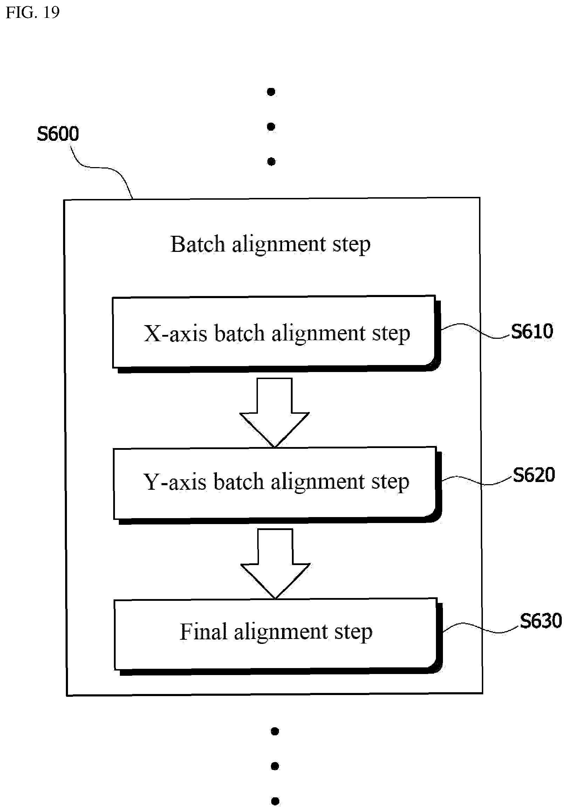

**In the batch alignment step (S600),** as the X-axis adjustment panel 230 and the Y-axis adjustment panel 250 of the alignment driving part 200 are finely adjusted, the multiple printed circuit boards P are aligned in batches by adjusting a certain distance along the X-axis and Y-axis lines within the alignment holes 602. That is, in a state where the optimal distance between the inner side surface of the alignment holes 602 of the alignment jig and the peripheral surface of the printed circuit board is set in the design, as described above, a slight change in position occurs during the suction process through the vacuum suction part, and the printed circuit board can be positioned on the exact mask's printing pattern by collectively adjusting this to the X-axis and Y-axis within the alignment hole. In the batch alignment step, the multiple printed circuit boards P enter and are positioned in the alignment holes 602 of the alignment jig 600 by the vacuum suction part 300 so that the upper surfaces of the multiple printed circuit boards P and the upper surface of the alignment jig 600 form the same plane, and detailed steps such as an X-axis batch alignment step (S610), a Y-axis batch alignment step (S620) and a final alignment step (S630) are included as shown in FIG. 19.

**In the X-axis batch alignment step (S610),** the X-axis adjustment panel 230 rail-coupled to the drive part base panel 210 micro-drives the vacuum suction part 300 along the X-axis according to the micro-driving of the X-axis alignment motor 220, and the multiple printed circuit boards P simultaneously move forward and backward at a certain distance in the X-axis direction within the alignment holes 602 according to the micro-driving of the vacuum suction part 300 to be collectively aligned and matched on the inner side surface of the Y-axis line within the alignment holes 602. That is, for example, when the distance from the peripheral surface of the printed circuit board to the inner side surface of the alignment hole is optimally 0.5 mm, the optimal alignment distance is 0.5 mm from the left and 0.5 mm from the right based on the X-axis in the case of the printed circuit board with the greatest change, and when the position is changed, the maximum change may be 1.0 mm by adding the distances on the left and right, as described above. Assuming that one or more positions of the multiple printed circuit boards change in the X-axis direction as described above, the distance to the left becomes 0.7 mm if one of the printed circuit boards changes 0.3 mm to the right, and the distance to the right becomes 0.8 mm if it changes 0.2 mm to the left. Accordingly, to adjust the whole equally, the X-axis adjustment panel 230 is moved up to 1.0 mm in the X-axis direction based on either the left or right side. If moved by 1.0 mm as described above, the printed circuit board changed by 0.3mm to the right or the printed circuit board changed by 0.2 mm to the left will both be aligned with the inner side surface of the alignment holes 602 of the Y-axis direction on either the left or right side of the X-axis direction. Of course, the remaining printed circuit boards placed in the correct position also coincide with the inner side surface of the alignment holes 602 in the Y-axis direction at the same time, so that the entire multiple printed circuit boards are aligned in the X-axis direction at the same time. Accordingly, the alignment adjustment is performed in the X-axis equally.

**In the Y-axis batch alignment step (S620),** the Y-axis adjustment panel 250 rail-coupled to the X-axis adjustment panel 230 micro-drives the vacuum suction part along the Y-axis according to the micro-driving of the Y-axis alignment motor 240, and the multiple printed circuit boards P simultaneously move left and right at a certain distance in the Y-axis direction within the alignment holes 602 according to the micro-driving of the vacuum suction part 300 to be collectively aligned and matched on the inner side surface of the X-axis line within the alignment holes 602. For example, when the distance from the peripheral surface of the printed circuit board to the inner side surface of the alignment hole is optimally 0.5 mm by the same method as in the X-axis batch alignment step, the optimal alignment distance is 0.5 mm from the front and 0.5 mm from the rear based on the Y-axis in the case of the printed circuit board with the greatest change, and when the position is changed, the maximum change may be 1.0 mm by adding the distances on the front and rear, as described above. Assuming that one or more positions of the multiple printed circuit boards change in the Y-axis direction as described above, the distance to the rear becomes 1.0 mm if one of the printed circuit boards changes 0.5 mm to the front, and the distance to the rear becomes 0.9 mm if it changes 0.1 mm to the left. Accordingly, to adjust the whole equally, the Y-axis adjustment panel 250 is moved up to 1.0 mm in the X-axis direction based on either the left or right side. If moved by 1.0 mm as described above, the printed circuit board changed by 0.5 mm to the front or the printed circuit board changed by 0.1 mm to the rear will both be aligned with the inner side surface of the alignment holes 602 of the X-axis direction on either the front or rear side of the Y-axis direction. Of course, the remaining printed circuit boards placed in the correct position also coincide with the inner side surface of the alignment holes 602 in the X-axis direction at the same time, so that the entire multiple printed circuit boards are aligned in the Y-axis direction at the same time. Accordingly, the alignment adjustment is performed in the Y-axis equally. Accordingly, the multiple printed circuit boards are aligned collectively by adjusting the X-axis and the Y-axis based on the inner side surface of the alignment hole, thereby reducing the alignment adjustment time, improving productivity and reducing production time.

**In the final alignment step (S630),** the multiple printed circuit boards P are simultaneously batch-aligned on the inner side surfaces of the alignment holes 602 on the X and Y-axis lines through the X and Y-axis batch alignment step, the vacuum suction part 300 moves to the center of the alignment hole, the X and Y-axis adjustment panels 230 and 250 are driven such that the printed circuit boards move to the position where the mask and the alignment jig are markedly aligned, and the center of each of the alignment holes 602 of the alignment jig 600, which enables solder printing, are aligned to the center of each of the multiple printed circuit boards P. That is, after the alignment adjustment along the X-axis and Y-axis, it moves to the position corresponding to the center of solder printing if the alignment driving part is adjusted by 0.5 mm along each of the X-axis and Y-axis as the optimal distance between the alignment holes and the printed circuit board is designed to be 0.5 mm, enabling precise solder printing and high-quality solder printing without printing defects.

**In the batch alignment finishing step (S700),** the multiple printed circuit boards P aligned in batches along the X-axis and Y-axis lines through the batch alignment step are fixed by suction without movement on the same plane as the upper surface of the alignment jig 600 by the vacuum suction part 300 such that solder printing is performed on the multiple printed circuit boards according to the printing pattern formed on the mask. That is, the printed circuit boards are completely fixed such that they are not pushed in the direction of travel of a squeegee during a process of printing with solder cream by the squeegee as the mask approaches. In addition, printing defects due to height changes between the upper surface of the alignment jig and the upper surfaces of the printed circuit boards are prevented by fixing the upper surface of the printed circuit board to be positioned on the same plane as the upper surface of the alignment jig, and the final solder printing is completed. Through the batch alignment device for screen printers according to the present invention and the batch alignment method using the same, multiple printed circuit boards can be aligned simultaneously and in batches on the X-axis and Y-axis, thereby improving productivity and shortening the overall production time, and precious printing and high-quality printing can be achieved similar to printing a single printed circuit board.

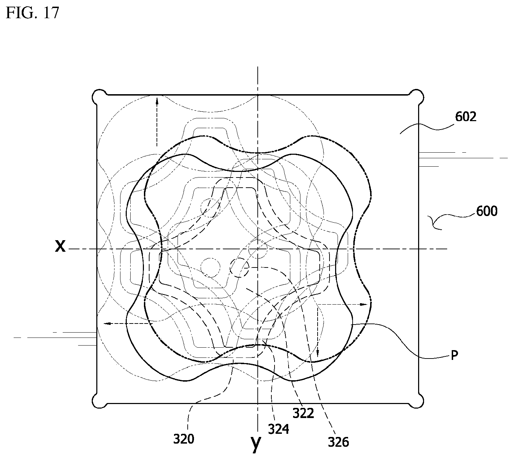

Meanwhile, the present invention illustrates a rectangular printed circuit board, but even a printed circuit board having a peanut shape, a circular shape, or an irregular shape required for special equipment, as shown in FIG. 17, may be aligned on the X-axis and Y-axis within the alignment hole by designing the optimal distance between the alignment hole and the printed circuit board. That is, since an existing shaft-based method aligns one side of a printed circuit board by pushing, it is difficult to set the alignment for a surface in the case of a printed circuit board with a curved surface, and if there is a curved part in the Y-axis direction even if one side is set, it is difficult to simultaneously align multiple printed circuit boards due to the phenomenon of being pushed along the curved surface. However, the present invention aligns printed circuit boards by moving them to corresponding positions on the X-axis and Y-axis directions within alignment holes even if they are printed circuit boards with an irregular shape, so it can be applied to printed circuit boards of various shapes.

In the above, the present invention has been described in detail as one embodiment, but the scope of the rights of the present invention is not limited thereto, and it is clear that numerous modifications and alterations are possible within the scope of technical ideas by those with common knowledge, and it can be said that it includes the scope of substantial equivalence with the embodiment of the present invention. The technical features will be described in detail.

## Claims

1. A batch alignment device for a screen printer, the batch alignment device comprising: a single mask provided on an upper part of the batch alignment device, wherein the mask is formed with multiple printing patterns corresponding to multiple printed circuit boards so that the multiple printed circuit boards can be solder-printed in a single printing operation on a printing part of a screen printer, the multiple printed circuit boards are arranged to correspond directly to the multiple printing patterns formed on the mask; a cylinder 120 where a cylinder rod 122 moves up and down to its lower center; and guide shafts 110 formed on its upper surface, and is formed in a plate shape, plate-shaped base panel 100 formed below the mask; an alignment driving part 200 coupled to guide shafts 110 on an upper surface of the base panel 100, configured to move up and down according to the operation of the cylinder rod 122 as a tip of the cylinder rod 122 is coupled to a center side, and formed to be adjusted by a certain distance on the X-axis and Y-axis on the plane; a vacuum suction part 300 coupled to an upper side of the alignment driving part 200 and provided to vacuum-absorb the printed circuit board P; a carrier boat 400 loaded below the mask wherein the multiple printed circuit boards P are placed on an upper surface of the carrier boat 400; a width adjustment conveyor unit 500 coupled to an upper surface of the base panel 100 such that a left-right width of the width adjustment conveyor unit 500 can be adjusted to correspond to a left-right width of the carrier boat 400 without interference with the alignment driving part 200 wherein the carrier boat 400 with the multiple printed circuit boards P placed thereon is fed along a wire belt to be positioned below the mask and to be symmetrically arranged forward and backward; and an alignment jig 600 formed in a plate shape, formed with multiple alignment holes 602 corresponding to multiple printed circuit boards P placed on the carrier boat 400 and having formed, aligned with the mask while being spaced upward from a carrier boat by a certain distance, and provided with both left and right ends that are placed and coupled on an upper side of the width adjustment conveyor unit 500.

2. The batch alignment device according to claim 1, wherein the alignment driving part 200 comprises a drive part base panel 210 provided with a guide housing 212 that is axially coupled with the guide shafts 110 formed on the upper surface of the base panel 100; and a base rod hole 214 formed in a center such that there is no interference with an up-and-down operation of the cylinder rod 122; an X-axis alignment motor 220 coupled to one of forward and backward side of an upper surface of the drive part base panel 210; a plate-shaped X-axis adjustment panel 230 coupled with a motor shaft part of the X-axis alignment motor 220, configured to move forward and backward along the X-axis corresponding to the forward and backward side of the plane according to driving of the alignment motor to simultaneously control movement of the multiple printed circuit boards placed in the carrier boat 400 in an X-axis direction so that an X-axis rail member 232 is attached to an lower surface, and provided with an X-axis rod hole 234 through which the cylinder rod 122 penetrates to ensure no interference in left-right movement along the X-axis in the center; a Y-axis alignment motor 240 coupled to one of left and right sides of an upper surface of the X-axis adjustment panel 230; and a plate-shaped Y-axis adjustment panel 250 coupled to a motor shaft part of the Y-axis alignment motor 240, provided with a Y-axis rail member 252 coupled to its lower surface to simultaneously adjust the multiple printed circuit boards P, placed in the carrier boat 400, in the Y-axis direction by moving left and right along the Y-axis corresponding to the left and right sides on the plane according to driving of the alignment motor, and provided with a rod insertion hole 254 formed such that the tip of the cylinder rod 122 is inserted into the center and a cylinder rod is coupled directly below the vacuum suction part 300 to raise and lower the vacuum suction part.

3. The batch alignment device according to claim 2, wherein diameters of the base rod hole 214 and the X-axis rod hole 234 of the alignment driving part 200 are formed to be larger than a distance for alignment adjustment of the front-rear Y-axis and the left-right X-axis, and are formed such that the cylinder rod 122 can move without interference within the base rod hole 214 during the forward and backward movement of the X-axis adjustment panel 230, and the cylinder rod 122 can move without interference within the X-axis rod hole 234 during the left and right movement of the Y-axis adjustment panel 250.

4. The batch alignment device according to claim 2, wherein the vacuum suction part 300 comprises a vacuum base 310 in which a vacuum base 310, in which the joint hole 312 to which the tip of the cylinder rod 122 is coupled, is formed on the same vertical line as the rod insertion hole 254 formed in the Y-axis adjustment panel 250 in the center of the lower surface, is fixedly coupled to the upper surface of the Y-axis adjustment panel, and is operated to move up and down together with the alignment driving part 200 according to the operation of the cylinder rod; and a vacuum element 320 stood up to correspond to the multiple printed circuit boards P placed on the carrier boat 400 on the upper surface of the vacuum base 310, provided with the vacuum part 322 recessed from the upper surface, the vacuum suction hole 324 formed in the center of a vacuum part, and provided with the contact-fixing band 326 formed along the circumference surface of the vacuum part to make minimum contact with the circumference side of the bottom surface of the printed circuit board P.

5. The batch alignment device according to claim 1, wherein the carrier boat 400 comprises multiple through-absorbing parts 410 formed as a square plate, and provided such that the vacuum suction part 300 on the plane is arranged to suck the bottom surface of the printed circuit board on the plane and lifts the printed circuit board to the alignment jig; and at least two anchoring pins provided in a pair on the outer circumference sides of the through-absorbing parts 410 such that movement of the printed circuit board can be restricted on the X-axis and Y-axis lines.

6. The batch alignment device according to claim 1, wherein the width adjustment conveyor unit 500 comprises an LM rail 510 formed symmetrically in the front and rear of the upper surface of the base panel 100; rail blocks 520 formed symmetrically forward and backward such that the rail blocks 520 are rail-coupled to the LM rail 510, and rail-move such that a pair of widths thereof facing each other left and right are narrowed or widened; width-adjusting spiral shafts 530 formed symmetrically between the LM rails 510 with positive and negative screw threads formed left and right based on the center and symmetrically formed front and back; a width-adjusting drive transmission part 540 formed with a belt and a pulley such that the width-adjusting spiral shafts 530 formed in a front-back symmetry can rotate forward and backward at the same time; a width-adjusting drive motor 550; and conveyor frames 560 formed in a " 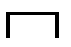 " shape such that the front and rear ends of the conveyor frames 560 are coupled to the front and rear rail blocks 520, the width-adjusting spiral shafts 530 are screw-coupled symmetrically left and right, and the widths are adjusted left and right by the width-adjusting spiral shafts 530 that rotate forward and backward by the width-adjusting drive motor 550 and the width-adjusting drive transmission part 540, and a wire belt is provided on the upper part of the conveyor frame 560 such that the carrier boat 400 on which the multiple printed circuit boards P are installed is loaded directly under the mask, which is on the side of the printing part of the screen printer, and a wire drive motor that drives the wire belt is connected to one side of the conveyor frame 560.

7. The batch alignment device according to claim 1, wherein the alignment jig 600 comprises multiple alignment holes 602 formed in a square plate shape to correspond to the multiple printed circuit boards P placed on the carrier boat 400, wherein, in a state where the bottom surfaces of the multiple printed circuit boards P are sucked by the vacuum suction part 300, the X-axis and Y-axis sides of the printed circuit boards are positioned inward by the operation of the cylinder rod so that the printed circuit boards are aligned in batches by the X-axis and Y-axis movement operations of the alignment driving part 200; and finish marks 604 formed on the upper surface of the alignment jig 600 to align with the mask.

8. The batch alignment device according to claim 7, wherein a distance from an inner side surface of the alignment holes 602 to an outer side surface of the printed circuit board P is 0.25 mm to 0.5 mm.

9. A batch alignment method, wherein a single mask having multiple printing patterns corresponding to the multiple printed circuit boards formed on the printing part of the screen printer is provided at the top such that the solder printing of the multiple printed circuit boards P can be performed in a single printing operation, and the alignment device of the screen printer is provided so that the multiple printed circuit boards are aligned so as to correspond directly to the multiple printing patterns formed on the mask, the batch alignment method comprising: a first alignment preparation step (S100) wherein the width of the conveyor frames 560 of the width adjustment conveyor unit 500 is adjusted to correspond to the width of the carrier boat 400 that is formed as a square plate and arranged to be first aligned by the anchoring pins 420 while the multiple printed circuit boards are placed around the through-absorbing parts 410 formed to correspond to the number of channels corresponding to the multiple printed circuit boards P to be printed, as described above; a second alignment preparation step (S200) wherein the alignment jig 600 is placed and fixed on the top of the conveyor frames 560 whose width is adjusted to correspond to the width of the carrier boat of the width adjustment conveyor unit 500, and the mask and the alignment jig 600 are matched and aligned; a carrier boat-loading step (S300) wherein the carrier boat 400 in which the multiple printed circuit boards P are placed is positioned below the alignment jig, in which the mask and the alignment jig are aligned, through the first alignment preparation step; a third alignment preparation step (S400) wherein the vacuum suction part 300 approaches the bottoms of the printed circuit boards placed in the carrier boat to vacuum-absorb by the lifting operation of the cylinder rod 122 of the base panel 100 provided below the carrier boat 400 loaded directly below the alignment jig 600 through the carrier boat-loading step, and the multiple printed circuit boards are simultaneously, batchwise separated to the upper side of the carrier boat; a fourth alignment preparation step (S500) wherein the cylinder rod 122 is further operated upward such that the multiple printed circuit boards P, which are separated in batches from the carrier boat by the vacuum suction part through the third alignment preparation step, simultaneously enter the alignment holes 602 of the alignment jig 600, so that the upper surface of the alignment jig 600 and the upper surface of the multiple printed circuit boards P, which entered the alignment holes in batches, are positioned on the same plane; a batch alignment step (S600) wherein as the X-axis adjustment panel 230 and the Y-axis adjustment panel 250 of the alignment driving part 200 are finely adjusted, the multiple printed circuit boards P are aligned in batches by adjusting a certain distance along the X-axis and Y-axis lines within the alignment holes 602; and a batch alignment finishing step (S700) wherein the multiple printed circuit boards P aligned in batches along the X-axis and Y-axis lines through the batch alignment step are fixed by suction without movement on the same plane as the upper surface of the alignment jig 600 by the vacuum suction part 300 such that solder printing is performed on the multiple printed circuit boards according to the printing pattern formed on the mask.

10. The batch alignment method according to claim 9, wherein, in the batch alignment step (S600), the multiple printed circuit boards P enter and are positioned in the alignment holes 602 of the alignment jig 600 by the vacuum suction part 300 so that the upper surfaces of the multiple printed circuit boards P and the upper surface of the alignment jig 600 form the same plane, the batch alignment step (S600) comprising: a X-axis batch alignment step (S610) wherein the X-axis adjustment panel 230 rail-coupled to the drive part base panel 210 micro-drives the vacuum suction part 300 along the X-axis according to the micro-driving of the X-axis alignment motor 220, and the multiple printed circuit boards P simultaneously move forward and backward at a certain distance in the X-axis direction within the alignment holes 602 according to the micro-driving of the vacuum suction part 300 to be collectively aligned and matched on the inner side surface of the Y-axis line within the alignment holes 602; a Y-axis batch alignment step (S620) wherein the Y-axis adjustment panel 250 rail-coupled to the X-axis adjustment panel 230 micro-drives the vacuum suction part along the Y-axis according to the micro-driving of the Y-axis alignment motor 240, and the multiple printed circuit boards P simultaneously move left and right at a certain distance in the Y-axis direction within the alignment holes 602 according to the micro-driving of the vacuum suction part 300 to be collectively aligned and matched on the inner side surface of the X-axis line within the alignment holes 602; and a final alignment step (S630) wherein the multiple printed circuit boards P are simultaneously batch-aligned on the inner side surfaces of the alignment holes 602 on the X and Y-axis lines through the X and Y-axis batch alignment step, the vacuum suction part 300 moves to the center of the alignment hole, the X and Y-axis adjustment panels 230 and 250 are driven such that the printed circuit boards move to the position where the mask and the alignment jig are markedly aligned, and the center of each of the alignment holes 602 of the alignment jig 600, which enables solder printing, are aligned to the center of each of the multiple printed circuit boards P.

11. The batch alignment method according to claim 10, wherein a distance from the inner side surface of the alignment holes 602 to the outer side surface of the printed circuit board P that has entered the alignment holes 602 at a position where the upper surface of the alignment holes 602 and the upper surface of the printed circuit board are aligned is 0.25 mm to 0.5 mm, and a predetermined distance for the multiple printed circuit boards (P) adsorbed on the vacuum-absorbing plate 300 to move in the X-axis and Y-axis directions within the alignment holes 602 and to be aligned in batches is 0.5 mm to 1.0 mm.
